(19) Europäisches Patentamt
European Patent Office
Office européen des brevets

(11) Veröffentlichungsnummer: **0 468 289 A2**

(12) **EUROPÄISCHE PATENTANMELDUNG**

(21) Anmeldenummer: **91111541.8**

(22) Anmeldetag: **11.07.91**

(51) Int. Cl.[5]: **C08F 8/14**, C08F 8/44, G03F 7/00

(30) Priorität: **21.07.90 DE 4023240**

(43) Veröffentlichungstag der Anmeldung: **29.01.92 Patentblatt 92/05**

(84) Benannte Vertragsstaaten: **AT BE DE FR GB IT**

(71) Anmelder: **BASF Aktiengesellschaft**
**Carl-Bosch-Strasse 38**
**W-6700 Ludwigshafen(DE)**

(72) Erfinder: **Telser, Thomas, Dr.**
**Langer Wiesenweg 13**
**W-6940 Weinheim(DE)**
Erfinder: **Meister, Martin, Dr.**
**Lincolnstrasse 19**
**W-6730 Neustadt(DE)**
Erfinder: **Koch, Horst, Dr.**
**Tiefenthaler Strasse 47**
**W-6719 Gruenstadt(DE)**

(54) **Modifizierte Emulsionspolymerisate insbesondere für in Wasser und wässrigen Lösungsmitteln entwickelbare photopolymerisierbare Aufzeichnungsmaterialien.**

(57) Modifizierte Polymerisate in Säureform oder in Form ihrer Salze aus
A) einem durch Emulsionspolymerisation erhaltenen Carboxylgruppen enthaltenden Copolymerisat
und
B) hierin durch partielle Pfropfung an den Carboxylgruppen eingeführten seitenständigen Resten der allgemeinen Formel I,

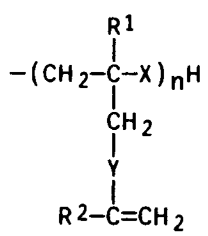

I,

in denen
$R^1$ ein Wasserstoffatom oder eine $C_1$- bis $C_5$-Alkylgruppe,
$R^2$ ein Wasserstoffatom oder eine $C_1$- bis $C_5$-Alkylgruppe,
X ein Sauerstoffatom, ein Schwefelatom oder eine Imingruppe,
Y eine Ester-, eine Amid-, eine Ether- oder eine $C_1$- bis $C_{10}$-Alkylengruppe bedeutet,
und $1 < n \leqq 100$ für die mittlere Anzahl n der pro umgesetzter Säurefunktion angelagerten Monomereinheiten gilt.

EP 0 468 289 A2

Die Erfindung betrifft modifizierte Polymerisate in Säureform oder in Form ihrer Salze aus

A) einem durch Emulsionspolymerisation hergestellten, Carboxylgruppen enthaltenden, Copolymerisat und

B) hierin durch partielle Pfropfung an den Carboxylgruppen eingeführten seitenständigen Resten der allgemeinen Formel I,

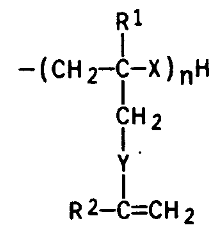

I,

in denen

$R^1$ ein Wasserstoffatom oder eine $C_1$- bis $C_5$-Alkylgruppe,
$R^2$ ein Wasserstoffatom oder eine $C_1$- bis $C_5$-Alkylgruppe,
X ein Sauerstoffatom, ein Schwefelatom oder eine Imingruppe,
Y eine Ester-, eine Amid-, eine Ether- oder eine $C_1$- bis $C_{10}$-Alkylengruppe bedeutet,

und $1 < n \leqq 100$ für die Anzahl n der pro umgesetzter Säurefunktion im Mittel angelagerten Monomereinheiten gilt.

Die Erfindung betrifft außerdem in Wasser und wäßrigen Lösungsmitteln entwickelbare photopolymerisierbare Aufzeichnungsmaterialien, die diese modifizierten Emulsionspolymerisate enthalten, sowie die mit diesen Aufzeichnungsmaterialien hergestellten reliefbildenden Druckplatten.

Druckplatten, die gegenüber Wasser, Ethanol und Ethanol/Essigesterver-Schnitten eine gute Beständigkeit aufweisen, sind bekannt. Diese Druckformen haben jedoch entscheidende Nachteile, so z.B. die Notwendigkeit stark toxischer Auswaschmittel (Tetrachlorethylen, US-A 4,423,135) oder brennbarer Auswaschmittel (Ethanol/Wasser Gemische, DE-A 27 22 421) oder stark alkalischer Entwicklungsmedien (EP-A 162 570) oder man ist auf den Einsatz von Flüssigharzen angewiesen (DE-A 33 19 676).

Ebenfalls bekannt sind lichtempfindliche Zusammensetzungen (Rezepturen) für Platten, die in reinem Wasser zur Druckform, dem Klischee, entwickelt werden können. Die Wasserentwickelbarkeit, d.h. die Wasserlöslichkeit der unbelichteten Teile, wird stets dadurch erreicht, daß saure bzw. basische Gruppen am polymeren Bindemittel durch niedermolekulare basische bzw. saure Rezepturbestandteile teilweise oder vollständig neutralisiert werden.

So werden z.B. in EP-A 261 910, EP-A 164 270 oder der DE-A 38 37 324 Schichten beschrieben, in denen die Neutralisation saurer Gruppen am Polymer durch zugesetzte Amine bzw. aminogruppenhaltige Monomere bzw. spezielle Aminoalkohole erreicht wird. Auch die Neutralisation mit Alkalihydroxiden und/oder Aminen ist vorbeschrieben (US-A 4,275,142).

Alle diese Schichten können den breiten Anforderungen an eine Druckplatte für Flexodruckfarben einschließlich der Beständigkeit gegenüber den obengenannten Farblösungsmitteln nicht genügen. Sie sind allenfalls für den Flexodruck von Zeitungen interessant, in dem Festigkeit nur für eine limitierte Auflagenzahl gefordert wird, und hauptsächlich Farben auf Wasserbasis eingesetzt werden.

Ziel der vorliegenden Arbeiten war es deshalb, Polymerisate für lichtempfindliche Schichten zu finden, deren unbelichtete Bereiche in reinem Wasser zum Klischee entwickelt werden können und deren belichtete Bereiche gute weichelastische Eigenschaften zeigen. Die hieraus hergestellten Druckplatten sollen mit Flexodruckfarben auf Ethanol-, Wasser-, Ethanol/Essigesterbasis verdruckt werden können und dabei für hohe Auflagen geeignet sein.

Überraschenderweise wurde gefunden, daß diese Anforderungen von den eingangs definierten modifizierten Emulsionspolymerisaten erfüllt werden.

Die erfindungsgemäßen Polymerisate enthalten bevorzugt 40 bis 80 Gew.-% mindestens eines konjugierten Diens $a_1$), 10 bis 50 Gew.-% mindestens einer ethylenisch $\alpha,\beta$-ungesättigten Säure $a_2$) sowie bis zu 50 Gew.-% mindestens eines ethylenisch ungesättigten Monomeren $a_3$).

Als konjugierte Diene $a_1$) können z.B. Butadien, Isopren oder Chloropren eingesetzt werden. Butadien wird bevorzugt verwendet. Als ethylenisch $\alpha,\beta$-ungesättigte Säuren $a_2$) können z.B. Acrylsäure, Methacrylsäure oder Itaconsäure eingesetzt werden. Methacrylsäure ist bevorzugt. Gegebenenfalls können die Säuren $a_2$) auch mehr als eine Carboxylgruppe enthalten.

Als mögliche weitere ethylenisch ungesättigte Monomere $a_3$) werden beispielsweise (Meth)-Acrylsäureester, (Meth)Acrylsäureamide, (Meth)Acrylsäurenitril und/oder Vinylaromaten verwendet.

Als Comonomere $a_3$) geeignete (Meth)Acrylsäureester und -amide sind insbesondere solche der allgemeinen Formel III geeignet,

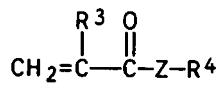

III,

worin $R^3$ ein Wasserstoffatom oder eine Methylgruppe bedeutet, $R^4$ einen Alkyl- oder Cycloalkylrest mit 1 bis 15 C-Atomen oder einen ω-Methyl-poly(alkylenoxid)-α-oxyl-Rest darstellt und Z ein Sauerstoffatom oder eine $NR^5$-Gruppe mit $R^5$ = H oder $C_1$-$C_4$-Alkyl bezeichnet. Beispiele geeigneter (Meth)Acrylsäureester und/oder -amide sind Methylacrylat, Methylmethacrylat, Ethylacrylat, Ethylmethacrylat, Propylacrylat, Propylmethacrylat, n-Butylacrylat, n-Butylmethacrylat, n-Pentylacrylat, n-Pentylmethacrylat, n-Hexylacrylat, n-Hexylmethacrylat, t-Butylacrylat, Cyclohexylacrylat, Cyclohexylmethacrylat, 2-Ethylhexylacrylat, 2-Ethylhexylmethacrylat, Dicyclopentadienylacrylat, Laurylacrylat, Laurylmethacrylat, ω-Methyl-poly(ethylenoxid)-α-yl-(meth)acrylat, ω-Methyl-poly(propylen-1,2-oxid)-α-yl-(meth)acrylat, ω-Methyl-poly(propylen-1,3-oxid)-α-yl-(meth)acrylat u.a., N-Ethylacrylamid, N-Methyl-N-butylmethacrylamid, N-Ethyl-N-(2-ethylhexyl)-acrylamid u.a. Bevorzugt sind n-Butylacrylat, 2-Ethylhexylacrylat, ω-Methyl-poly(ethylenoxid)-α-yl-acrylat und Dicyclopentadienylacrylat.

Besonders bevorzugt werden ungesättigte Monomere $a_3$) mit hydrophobem Rest eingesetzt, beispielsweise 2-Ethylhexylacrylat, Laurylacrylat und Butylacrylat.

Die Zusammensetzung der durch partielle Pfropfung entstehenden eingeführten seitenständigen Reste entspricht der allgemeinen Formel I.

Ein bevorzugter seitenständiger Rest B) wird hieraus mit $R^1$ = H, $R^2$ = $CH_3$, X = O und Y = COO erhalten.

Das aus den Komponenten $a_1$), $a_2$) und $a_3$) bestehende Copolymer wird durch Emulsionspolymerisation nach dem bekannten Stand der Technik (z.B. CA-A 614 181, US-A 3,895,082) hergestellt.

Bei der Emulsionspolymerisation werden die Monomeren unter Zuhilfenahme geeigneter Emulgatoren in Wasser dispergiert. Üblicherweise werden anionische und/oder nichtionogene Emulgatoren zur Stabilisierung der Latices verwendet. Beispiele für geeignete Emulgatoren sind Alkali- oder Ammoniumlaurylsulfat, $C_{10}$-$C_{18}$-Alkylsulfate, $C_{10}$-$C_{18}$-Alkylsulfonate, Alkylarylsulfonate, Sulfate von Alkylphenolethoxylaten, Alkylphenolethoxylate, Alkylalkoholethoxylate oder anionische organische Phosphate oder Mischungen hiervon. Die Emulgatoren werden im allgemeinen in einer Menge von 0,25 bis 4 Gew.-%, bezogen auf die Summe der Reaktanden, verwendet.

Der Reaktionsmischung sind in der Regel wasserlösliche Polymerisationsinitiatoren in einer Menge von 0,05 bis 5 Gew.-%, bezogen auf die Summe der polymerisierbaren Monomeren, beigefügt. Geeignete Initiatoren sind beispielsweise die gängigen radikalerzeugenden Verbindungen wie Alkaliperoxodisulfate, Hydroperoxide oder Peroxide, gegebenenfalls in Kombination mit Reduktionsmitteln wie Natriumbisulfit oder Natriumhydroxymethylsulfinat, oder Azoverbindungen wie beispielsweise Azobisisobutyronitril (AIBN).

Um Produkte mit ausreichender Löslichkeit zu erhalten, wird bei der Emulsionspolymerisation vorzugsweise ein Molekulargewichtsregler in einem Anteil von 0,1 bis 5 Gew.-% zugesetzt. Geeignete Regler sind z.B. Mercaptane. Bevorzugt wird t-Dodecylmercaptan.

Die Emulsionspolymerisation kann im Batch-Betrieb, im halbkontinuierlichen ("continuous monomer addition") oder im kontinuierlichen Betrieb (siehe "Fitzer, Fritz: Technische Chemie, Springer Verlag, 1982) sowie ein- oder mehrstufig (siehe EP-A-356 953) gefahren werden. Durch die kontrollierte Zugabe der einzelnen Monomere $a_1$) bis $a_3$) kann insbesondere der Einbau der Säuregruppen in das polymere Bindemittel gesteuert werden. So können auch die Eigenschaften der Druckplatten (Auswaschzeiten, Quellbeständigkeit) gezielt verändert werden.

Die Emulsionspolymerisation wird im allgemeinen bei Temperaturen zwischen 20 und 100 °C, vorzugsweise zwischen 40 und 70 °C, durchgeführt.

Eventuell nicht vollständig umgesetzte Monomere können, wie bei der Emulsionspolymerisation üblich, durch Wasserdampfdestillationsverfahren, gegebenenfalls im Vakuum, entfernt werden (Vgl. Houben-Weyl, Methoden der organischen Chemie, 4. Auflage, Band 14/1, Seiten 468, 469).

Zur Erzeugung der erfindungsgemäßen modifizierten Emulsionspolymerisate können auch Core-Shell-Mikrogele der in EP-A 356 954 beschriebenen Art verwendet werden.

Zur Erzeugung des erfindungsgemäßen Aufzeichnungsmaterials wird das Copolymer, das nach der

Emulsionspolymerisation in der Säureform vorliegt, teilweise gepfropft und gegebenenfalls anschließend durch Neutralisation teilweise oder vollständig in die salzartige Form überführt.

Bevor das Copolymer weiter umgesetzt wird, wird das Wasser der Emulsion entfernt. Bevorzugt wird die Emulsion gefriergetrocknet. Anschließend wird das Polymer wieder in geeigneten Lösungsmitteln wie Toluol, THF oder Aceton in Lösung gebracht. Alternativ kann das Wasser nach Zugabe eines unpolaren Lösungsmittels wie beispielsweise Toluol durch Destillation abgetrennt (ausgekreist) werden. Hierbei wird das Toluol/Wasser-Gemisch abdestilliert und der Toluolanteil wieder der Polymerlösung bzw. -emulsion zugeführt.

Eine weitere sehr elegante Methode der Entwässerung besteht darin, die Emulsion direkt in einen Extruder einzuspeisen, dort zu entwässern (beispielsweise durch Entgasen im Vakuum) und das Copolymer in der Schmelze weiter umzusetzen (siehe unten) und mit den Rezepturbestandteilen zu vermischen. Bei der Umsetzung im Extruder ist die Reihenfolge der zugesetzten Komponenten (Pfropfungsreagenz, Neutralisationsreagenz) im wesentlichen ohne Bedeutung. Diese Methode könnte insbesondere für die großtechnische Produktion im halbkontinuierlichen Betrieb bedeutsam sein.

Bei allen Methoden müssen die bei der Emulsionspolymerisation eingesetzten Hilfsstoffe (Regler, Emulgatoren) nicht entfernt werden. Die Bestandteile enthält dann auch die Druckplattenrezeptur.

Zur eventuellen Reinigung der Polymeren können die bekannten Techniken der Koagulation, Filtration, des Waschens und anschließenden Trocknens herangezogen werden.

Nach Entfernung des Wassers werden die polymeranalogen Umsetzungen der Pfropfung und der Neutralisation durchgeführt. Bei der Weiterverarbeitung in Lösung wird vorzugsweise zuerst die Pfropfung durchgeführt, da sich durch die Neutralisation die Viskosität der Lösung stark erhöht und eine weitere Umsetzung erschwert wird.

Die teilweise Pfropfung wird durch partielle oder vollständige Umsetzung der Carboxylgruppen in den Emulsionspolymerisaten mit Verbindungen der allgemeinen Formel II erreicht. $R^1$, $R^2$, X und Y haben hierbei die gleiche Bedeutung wie in Formel I.

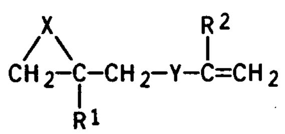

II

Die Umsetzung von Carboxylgruppen enthaltenden niedermolekularen Verbindungen mit Verbindungen der allgemeinen Formel (II) unter Ringöffnung ist an sich bekannt und beispielsweise in der Firmenschrift "Reactive Monomers", Nissan Blemmer G, High Polymer Modifiers (Nippon Oil and Fats, Co. Ltd, 1968) beschrieben. Auch die polymeranaloge Umsetzung an carboxylgruppenhaltigen Polymeren, die durch Hochdruckpolymerisation hergestellt wurden, ist bekannt und in der EP-A 231 002 beschrieben. Hierbei und im folgenden wird unter polymeranaloger Umsetzung verstanden, daß stets eine Carboxylgruppe mit einer Formeleinheit (II) reagiert, so daß Polymere mit entlang der Polymerkette gleichmäßig verteilten (hängenden) reaktiven Doppelbindungen entstehen. Die quantitative Umsetzung der Carboxylgruppen kann durch Bestimmung der Säurezahl verfolgt werden.

Die Umsetzung der erfindungsgemäßen Emulsionspolymerisate mit Verbindungen der allgemeinen Formel (II) verläuft in anderer Art und Weise. Dies sei am Beispiel des Glycidylmethacrylats (GMA) erläutert.

Zwar verläuft die Ringöffnung des Glycidylmethacrylates quantitativ (die IR-Banden bei 915 und 850 $cm^{-1}$ verschwinden vollständig), eine der Menge des eingesetzten GMA entsprechende Abnahme der Säurezahl wird jedoch nicht beobachtet.

Dies kann damit erklärt werden, daß ein Molekül Glycidylmethacrylat nach erfolgter Umsetzung mit einer Säurefunktion weitere Einheiten des Glycidylmethacrylats spaltet und anlagert, also die erfindungsgemäßen Pfropfcopolymere entstehen.

Die Anzahl n der pro umgesetzter Säurefunktion im Mittel angelagerten ("aufgepfropften") Monomereinheiten kann durch Vergleich der experimentell ermittelten Säurezahl (mgKOH/g Polymer) mit der theoretisch bei äquivalenter Umsetzung erwarteten Säurezahl berechnet werden. Man erhält für n im allgemeinen Werte zwischen 2 und 100, vorzugsweise zwischen 2 und 20.

In einer bevorzugten Verfahrensweise setzt man die Emulsionscopolymerisate A) mit den Verbindungen der Formel II in Lösungsmitteln wie Tetrahydrofuran, Toluol, Ethylbenzol, Methylethylketon, Methylisobutylketon oder Gemischen aus denselben um. Zu den Lösungen der Emulsionscopolymerisate A fügt man gegebenenfalls p-Dimethylaminopyridin, N-Methylimidazol, Tetraalkylammoniumsalze und/oder andere Basen als Katalysator (die Anspringtemperatur wird erniedrigt) und z.B. 2,6-Di-tert.-butyl-p-kresol oder N-Nitrosodiphenylamin als Inhibitor zu. Zu diesen Lösungen tropft man die gewünschte Menge an Oxiran-2-yl-bzw. Glycidyl-, Thiiran-2-yl- oder Aziridin-2-yl-Verbindung mit einer solchen Geschwindigkeit, daß die Temperatur des Reaktionsgemisches bei 40 bis 110 °C, bevorzugt über 80 °C, liegt. Gegebenenfalls wird die Temperatur durch Heizen oder Kühlen eingestellt. Nach dem Zutropfen wird die Reaktionsmischung mit Vorteil 3 bis 10 Stunden lang bei 50 °C nachgerührt und das Lösungsmittel in geeigneter Weise, beispielsweise durch Vakuumdestillation entfernt.

In einer weiteren vorteilhaften Verfahrensweise setzt man das Copolymerisat A) zusammen mit den vorstehend genannten Verbindungen auf einem Kneter um, z.B. bei 125 bis 180 °C während 3 bis 60 Minuten, oder führt die Reaktion in einem Zweischneckenextruder durch, mit Vorteil mit einer Verweilzeit von 5 bis 10 Minuten (siehe oben).

Die zu pfropfende Komponente der Zusammensetzung II wird in einem Anteil von 3 bis 30, vorzugsweise 4 bis 10 und besonders bevorzugt 4 bis 8 Gew.-%, bezogen auf das Emulsionspolymerisat, eingesetzt. Höhere und niedrigere Anteile sind zwar möglich, doch ergeben höhere Anteile häufig zu harte Schichten, geringere Anteile häufig eine zu geringe Löslichkeitsdifferenzierung zwischen belichteten und unbelichteten Teilen des Aufzeichnungsmaterials bzw. eine zu niedrige Vernetzungsdichte in den belichteten Teilen des Aufzeichnungsmaterials.

Im Vergleich zur polymeranalogen Umsetzung hat die Pfropfreaktion wesentliche Vorteile. Zum einen kann die Zahl der eingeführten reaktiven Doppelbindungen erhöht werden, ohne daß der Anteil der Säuregruppen im Ausgangspolymer erhöht werden muß. Die Vernetzungsgeschwindigkeit der lichtempfindlichen Mischung kann so erhöht werden, ohne daß gleichzeitig eine starke Erhöhung der Härte der belichteten Schicht in Kauf genommen werden muß. Zum anderen bleiben nach erfolgter Pfropfung noch genügend nicht umgesetzte Säurefunktionen übrig, die im anschließenden Neutralisierungsschritt (siehe unten) zur Erzielung der Wasserlöslichkeit der Schichten teilweise oder vollständig mit entsprechenden Basen zu salzartigen Strukturen umgesetzt werden können.

Überraschenderweise wird durch die Pfropfreaktion auch die Wasserlöslichkeit der nicht belichteten Schichten stark verbessert, ohne daß die Quellbeständigkeit der belichteten Schichten abnimmt. Eine ausgezeichnete Löslichkeitsdifferenzierung wird somit erzielt.

In den erfindungsgemäßen Polymeren können gegebenenfalls weitere seitenständige Reste C) der allgemeinen Formel IV,

$$-(CH_2-\overset{\displaystyle H}{\underset{\displaystyle R^6}{C}}-X)_mH \qquad IV,$$

worin

X ein Sauerstoffatom, ein Schwefelatom oder eine Imingruppe,

$R^6$ eine polare Gruppe, ein Wasserstoffatom oder einen Alkylrest bedeutet

und

$1 \leqq m \leqq 100$ gilt, eingeführt sein.

Wünscht man, zusätzlich zu den olefinisch ungesättigten Resten B), noch Reste C) einzuführen, dann werden zur Einführung der Reste B) die Carboxylgruppen nur partiell umgesetzt, so daß pro Molekülkette mindestens noch eine Carboxylgruppe für die Einführung des Restes C) zur Verfügung steht. Um in den Endprodukten noch freie Carboxylgruppen für eine gegebenenfalls erfolgende Salzbildung zur Verfügung zu haben, ist es vorteilhaft, insgesamt nur einen Teil der Carboxylgruppen bei der Einführung der Reste B) und gegebenenfalls C) reagieren zu lassen.

Für die Umsetzung zur fakultativen Einführung von Resten C) sind z.B. geeignet Oxiran, Aziridin, Thiiran, 2-Methyloloxiran, 2-Methylolaziridin, 2-Methylolthiiran oder 2[ω-Methyl-poly(ethylenoxid)]-oxiran, ferner Verbindungen, welche Glycidyl-, Oxiranyl-, Aziridinyl- oder Thiiranyl-Reste und stark polare Gruppen enthalten.

Die Einführung der Reste C) erfolgt unter denselben Reaktionsbedingungen wie die der Reste B), wobei es in Abhängigkeit von der Natur des einzuführenden Restes C) und der Reaktionsbedingungen zu einer polymeranalogen Umsetzung ($m = 1$) oder aber zu einer Pfropfungsreaktion ($m > 1$) kommt.

Bei der anschließenden Neutralisierung werden die Pfropfcopolymere mit Basen wie beispielsweise Alkalihydroxiden, Alkalialkoholaten oder Acetaten, Ammoniak oder Aminen, oder anderen Basen (vgl. die unten angeführten Salzbildner) teilweise neutralisiert. Hierzu gibt man das Neutralisationsagens bei erhöhter

Temperatur in die Polymerlösung. Die Alkalihydroxide werden in Form wäßriger bzw. alkoholischer Lösungen dosiert. Die Viskosität der Polymerlösung steigt durch die Neutralisation stark an.

Eine Reaktionsdauer beispielsweise von 3 h bei 80 °C reicht zur quantitativen Umsetzung der Basen aus. Der Anteil des Neutralisationsagens, bezogen auf das Pfropfcopolymerisat, liegt im Bereich von 3 bis 10 Gew.-%. Bei geringeren Anteilen sind die Schichten nicht wasserlöslich, bei höheren Anteilen ist die Wasserempfindlichkeit sowohl der unbelichteten als auch der belichteten Schicht ungenügend.

Die erfindungsgemäßen teilweise neutralisierten Polymerisate $b_1$) werden mit Vorteil für die Herstellung von durch Photopolymerisation vernetzbaren Massen, Druckplatten, Reliefplatten und Photoresists verwendet. Dazu werden ihnen geeignete Photoinitiatoren $b_3$) in wirksamen Mengen sowie gegebenenfalls geeignete photopolymerisierbare Monomere $b_2$), Salzbildner, Weichmacher, Inhibitoren der thermisch initiierten Polymerisation, Farbstoffe und Pigmente, Mittel zur Verbesserung der Reliefstruktur, Vernetzungshilfsmittel, Antioxidantien, Füllstoffe, Flußmittel oder Formtrennmittel beigegeben. Mischungen aus den erfindungsgemäßen Polymerisaten und diesen geeigneten Zusatzstoffen werden im folgenden der Kürze halber als "Gemische" bezeichnet.

Geeignete Photoinitiatoren $b_3$) sind beispielsweise Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethyl-acetal; oder Acyldiarylphosphinoxide gemäß DE-A 29 09 992; oder substituierte und unsubstituierte Chinone, wie Ethylanthrachinon, Benzanthrachinon, Benzophenon oder 4,4'-Bis(dimethylamino)benzophenon. Sie können allein oder im Gemisch miteinander oder in Verbindung mit Coinitiatoren verwendet werden, z.B. Ethylanthrachinon mit 4,4'-Bis(dimethylamino)benzophenon, Benzoinmethylether mit Triphenylphosphin, Diacylphosphinoxide mit tertiären Aminen oder Acyldiarylphosphinoxide mit Benzildimethylacetal. In den Gemischen werden sie in einer Menge von 0,001 bis 10, vorteilhaft 0,1 bis 5 und insbesondere 0,3 bis 2 Gew.%, bezogen auf ein Gemisch, verwendet, wobei die Menge mitbestimmt wird von der Mitverwendung photopolymerisierbarer Monomerer.

Geeignete photopolymerisierbare Monomere $b_2$) sind beispielsweise aus US-A 2 760 863 oder US-A 3 060 023 bekannt. Sie besitzen einen Siedepunkt von über 100 °C bei Atmosphärendruck und ein Molgewicht von bis zu 3000, insbesondere von bis zu 2000. Geeignet sind die Ester der Acrylsäure und/oder Methacrylsäure mit ein- oder mehrwertigen Alkoholen, z.B. Butylacrylat, Butylmethacrylat, 2-Ethylhexylacrylat, Lauryl(meth)acrylat, Ethlenglykol-di(meth)acrylat, Butandiol-1,4-di(meth)acrylat, Neopentylglykol-di-(meth)acrylat, 3-Methylpentandiol-di(meth)acrylat, 2-Hydroxipropyl(meth)acrylat, 2-Hydroxiethyl(meth)acrylat, 1,6-Hexandiol-di(meth)acrylat, 1,1,1-Trimethylolpropantri(meth)acrylat, Di-, Tri- und Tetraethylenglykoldi-(meth)acrylat, Tripropylenglykol-di(meth)acrylat oder Pentaerythrit-tetra(meth)acrylat, des weiteren Poly-(ethylenoxid)di(meth)acrylat, $\omega$-Methylpoly(ethylenoxid)-$\alpha$-yl-(meth)acrylat, N,N-Diethylaminoethylacrylat oder ein Umsetzungsprodukt aus 1 Mol Glycerin, 1 Mol Epichlorhydrin und 3 Mol Acrylsäure; die Vinylester aliphatischer Monocarbonsäuren, z.B. Vinyloleat; die Vinylether von Alkoholen, z.B. Octadecylvinylether und Butandiol-1,4-divinylether; die Diester von Fumar- und Maleinsäure; oder die Umsetzungsprodukte aus OHterminierten, oligomeren Polybutadienen mit Maleinsäure oder (Meth)Acrylsäure, d.h. oligomere Polybutadiene mit aktivierten, photopolymerisierbaren olefinischen Doppelbindungen. In den Gemischen werden sie - einzeln oder als Mischung - in einer Menge von 1 bis 40, vorteilhafterweise 2 bis 30 und insbesondere 5 bis 20 Gew.%, bezogen auf ein Gemisch, verwendet.

Geeignete Salzbildner sind

1. anorganische Metallverbindungen wie Oxide, Hydroxide, Alkoxide mit 1 bis 4 C-Atomen im Alkylrest oder Carbonate der Kationen von Na, K, Li, Mg, Ca, Sr, Ba, Al, Ga, In, Ge, Sn, Pb, Sb, Bi, Zn, Cd, Sc, Y, La, Ti, Zr, Hf, V, Nb, Ta, Cr, Mo, W, Mn, Re, Fe, Co, Ni, Pd oder den Lanthaniden oder
2. organische Metallverbindungen der Struktur (V)

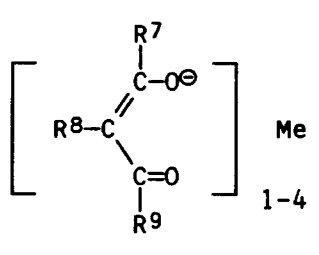

(V),

worin Me ein Kation eines der vorstehend genannten Elemente bedeutet, $R^7$, $R^8$ und $R^9$ gleichartige oder verschiedenartige Alkyl-, Cycloalkyl-, Aryl- oder Alkylarylgruppen darstellen, wobei die Reste $R^7$ und $R^9$ cyclisch über Ringsysteme miteinander verknüpft sein können und wobei ferner $R^8$ auch noch

ein Wasserstoffatom kennzeichnen kann, oder

3. Ammoniak oder

4. mehrfachfunktionelle Amine wie Ethylendiamin, Diethylentriamin, N-Methyl-N-ethyl-ethylendiamin, N,N-Dimethyl-ethylendiamin, N,N'-Diethylethylen-diamin, N,N,N',N'-Tetramethylethylendiamin, N,N,N'',N'' Tetramethylethylentriamin, 1,3-Diaminopropan 1,4-Diaminobutan, Pyrazin oder Polyvinylpyridin oder

5. Hydrazin oder

6. cyclische Amine, z.B. Morpholin, oder

7. hydroxygruppenhaltige Amine, z.B. Ethanolamine, oder

8. ethoxylierte und/oder propoxylierte Amine.

Bevorzugt sind die Oxide, Hydroxide, Alkoxide, Carbonate und Acetylacetonate von $Na^{\oplus}$, $Li^{\oplus}$, $Mg^{2\oplus}$, $Ca^{2\oplus}$, $Sr^{2\oplus}$, $Ba^{2\oplus}$, $Al^{3\oplus}$, $Sn^{2\oplus}$, $Sb3^{\oplus}$ und $Zn^{2\oplus}$,wobei Bis(acetylacetonato)-Zn(II), MgO und LiOH besonders bevorzugt sind.

Vorteilhafterweise werden sie in einer Menge von 0,05 bis 20, vorzugsweise 0,5 bis 15 und insbesondere 1 bis 10 Gew.%, bezogen auf ein erfindungsgemäßes Polymerisat, verwendet.

Geeignete Weichmacher sind z.B. modifizierte und unmodifizierte Naturöle und -harze wie paraffinische oder naphthenische Öle sowie Erdölharze oder Pentaerythritolester von hydriertem Kollophonium; Alkyl-, Alkenyl-, Arylalkyl- oder Arylalkenylalkoholester von Säuren wie Zitronensäure, Essigsäure, Propionsäure, Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze wie Oligostyrol, oligomere Styrol-Butadien-Copolymerisate, Oligo-α-methylstyrol, oligomere α-Methylstyrol-Vinyltoluol-Copolymerisate, flüssige 1,2- oder 1,4-Oligobutadiene, Oligopentadiene, flüssige oligomere Acrylnitril-Butadien-Copolymerisate sowie Polyterpen-, Polyacrylat-, Polyester- oder Polyurethanharze, synthetische Polymere wie Polyethylen oder Ethylen-Propylen-Dien-Kautschuke; ω-Methyl-oligo(ethylenoxid); oder Sulfonamide. Ein besonders geeignetes Sulfonamid ist N-n-Butylbenzolsulfonsäureamid (Cetamoll® BMB der BASF AG). Von Vorteil sind Mengen von 1 bis 20 Gew.%, bezogen auf ein Gemisch. Mengen bis zu 30 Gew.-% sind jedoch möglich.

Geeignete Inhibitoren der thermisch initiierten Polymerisation, die im allgemeinen in einer Menge von 0,001 bis 2 Gew.%, bezogen auf ein Gemisch, zugesetzt werden und die keine nennenswerte Eigenabsorption in dem aktinischen Bereich, in dem der Photoinitiator absorbiert, aufweisen, sind z.B. Hydrochinon, p-Methoxyphenol, 2,6-Di-tert.-butyl-p-kresol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze, des N-Nitrosocyclohexylhydroxylamins.

Geeignete Farbstoffe, Pigmente oder photochrome Zusätze $b_5$) werden den Gemischen in einer Menge von 0,0001 bis 2 Gew.%, bezogen auf ein Gemisch, zugesetzt. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie - ebenso wenig wie die Inhibitoren der thermisch initiierten Polymerisation - die Photopolymerisation der Gemische stören. Geeignet sind z.B. die löslichen Phenazinium-, Phenoxazinium-, Acridinium und Phenothiaziniumfarbstoffe, wie Neutralrot (C.I. 50040), Safranin T (C.I. 50240), Rhodanilblau, dem Salz bzw. Amid aus Rhodamin D (Basic Violett 10), Rhodanilblau, dem Salz bzw. Amid aus Rhodamin D (Basic Violett 10, C.I. 45170), Methylenblau B (C.I. 52015), Thioninblau G (C.I. 52025), Thioninblau G (C.I. 52025) oder Acridinorange (C.I. 46005); sowie auch Solvent Black 3 (C.I. 26150). Diese Farbstoffe werden auch zusammen mit einer hinreichenden Menge eines Reduktionsmittels verwendet, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexyl-hydroxylamins, vorzugsweise die Kalium-, Calcium- und Aluminiumsalze. Letztere können, wie erwähnt, zugleich als Inhibitoren der thermisch initiierten Polymerisation dienen. Die Reduktionsmittel werden im allgemeinen in Mengen von 0,005 bis 5 Gew.%, bezogen auf ein Gemisch, zugesetzt, wobei sich in vielen Fällen der Zusatz eines 3- bis 10fachen der Menge an mitverwendetem Farbstoff bewährt hat.

Geeignete Mittel zur Verbesserung der Reliefstruktur der aus den Gemischen hergestellten Druckformen sind beispielsweise 9,9'-Dianthronyl und 10,10'-Bisanthron gemäß DE-A 27 20 560.

Die Gemische können ferner Vernetzungshilfsmittel wie die in US-A 4 179 531 und US-A 4 234 676 beschriebenen tri- und tetrafunktionellen Mercaptoverbindungen enthalten.

Zum Schutz der Gemische vor oxidativem und thermooxidativem Abbau durch Luftsauerstoff können ihnen wirksame Mengen an geeigneten Antioxidantien zugesetzt werden, z.B. sterisch gehinderte Monophenole wie 2,6-Di-tert.-butyl-p-kresol; alkylierte Thiobis- und Alkylidenbisphenole wie 2,2'-Methylen-bis-(4-methyl-6-tert.-butylphenol) oder 2,2'-Bis-(1-hydroxi-4-methyl-6-tert.-butylphenyl)sulfid; Hydroxibenzyle wie 1,3,5-Trimethyl-2,4,6-tris-(3,5-di-tert.-butyl-4-hydroxibenzyl)benzol; Triazine wie 2-(4-Hydroxi-3,5-tert.-butyl-anilino)-4,6-bis-(n-octylthio)-1,3,5-triazin; polymerisiertes Trimethyldihydrochinon; Zinkdibutyldithiocarbamat; Dilaurylthiodipropionat; oder Phosphite wie Tris(nonylphenyl)phosphit. Von Vorteil sind Mengen von 0,001 bis 5 Gew.%, bezogen auf ein Gemisch.

Geeignete nicht mischbare polymere oder nicht polymere organische und anorganische Füllstoffe oder Verstärkungsfüllstoffe sind solche, die für die Wellenlängen des zur Belichtung der erfindungsgemäßen Gemische verwendeten Lichts im wesentlichen durchlässig sind, dieses nicht streuen und in ihrem Brechungsindex weitgehend dem betreffenden Gemisch angepaßt sind, z.B. Polystyrol, organophiles Siliciumdioxid, Bentonit, Kieselsäure, organophiles Aluminiumoxid, Glaspulver, kolloidaler Kohlenstoff sowie verschiedene Arten von Farbstoffen und Pigmenten. Diese Zusatzstoffe werden in Mengen verwendet, die mit den gewünschten Eigenschaften der erfindungsgemäßen Materialien variieren. Die Füllstoffe haben den Vorteil, daß sie die Festigkeit der erfindungsgemäßen Gemische verbessern, die Klebrigkeit verringern helfen und unter Umständen als farbgebende Mittel wirksam sind.

Die Gemische können ferner noch geeignete Flußmittel wie Calciumstearat und/oder Formtrennmittel wie Talkum in wirksamen Mengen enthalten.

Für die Verwendung der Gemische als photopolymerisierbare Kleber und Dichtungsmassen empfiehlt es sich, klebrigmachende Harze, z.B. Paraffinharze, Kollophoniumester, Polyterpene, Cumaron-Inden-Harze oder Verbindungen gemäß US-A 4 133 731 zuzusetzen.

Der Anteil der gegebenenfalls angewendeten Zusatzstoffe soll im allgemeinen 50, insbesondere 40 Gew.% eines Gemisches nicht überschreiten.

Die Herstellung der Gemische aus den Komponenten weist keine methodischen Besonderheiten auf; es können die üblichen Knet-, Misch- und Lösungstechniken angewendet werden.

Die so erhaltenen Gemische können direkt als photovernetzbare Kleber und Dichtungsmassen verwendet oder zu photovernetzbaren Folien und zu Platten, insbesondere Druckplatten, Reliefplatten und Photoresists, weiterverarbeitet werden. Dazu werden sie in üblicher Weise durch Gießen aus einer Lösung, Heißpressen, Kalandrieren oder Extrudieren zu Flächengebilden der gewünschten Dicke geformt. Diese richtet sich im Falle der Formen in erster Linie nach dem Verwendungszweck der Flächengebilde und variiert im allgemeinen von 0,001 bis 7, insbesondere 0,025 bis 6,5 mm, da beispielsweise daraus hergestellte Druckformen dieser Dicke für die Mehrzahl der Drucktechniken geeignet sind. Im Falle Folien ist die Dicke beliebig.

Die Flächengebilde können als solche zu Druckformen, Reliefformen und photovernetzbaren Photoresists verarbeitet werden; es ist jedoch üblich, sie im Verbund mit anderen schichtenförmigen Materialien herzustellen und dann erst weiterzuverarbeiten. Ein solcher Verbund wird allgemein als "Mehrschichtenelement" und das darin enthaltene Flächengebilde als "reliefbildende Schicht (RS)" bezeichnet.

Üblicherweise enthält ein solches Mehrschichtenelement eine reliefbildende Schicht (RS), die mit einem dimensionsstabilen Träger (T) haftfest verbunden ist. Der dimensionsstabile Träger (T) wiederum kann mit einer weichelastischen Unterschicht (U) gemäß DE-A 24 44 118 unterlegt sein. Des weiteren kann auf die dem Träger (T) abgewandten Seite der Schicht (RS) eine Deckschicht (DS) und/oder eine Deckfolie (DF) aufgebracht werden. Werden Deckschicht (DS) und Deckfolie (DF) gemeinsam verwendet, dann liegt (DS) der Schicht (RS) direkt auf, und es kann sich zwischen (DS) und (DF) noch eine Antihaftschicht (AS) befinden. Ferner kann eine haftfeste Verbindung zwischen (T) und (RS) und gegebenenfalls (RS) und (DF) mit Hilfe einer Haftschicht (HS) erreicht werden.

Als dimensionsstabile Träger (T) können Platten, Folien oder konische Röhren (sleeves) aus Metallen wie Stahl, Aluminium, Kupfer oder Nickel oder aus Kunststoffen wie Polyethylenterephthalat, Polybutylenterephthalat, Polyamid oder Polycarbonat verwendet werden. Daneben kommen noch Gewebe und Vliese, z.B. Glasfasergewebe oder Verbundmaterialien aus z.B. Glasfasern und Kunststoffen wie Polyethylenterephthalat in Frage.

Als Haftschichten (HS) werden mit Vorteil etwa 0,5 bis 40 $\mu$m dicke Haftlackschichten gemäß DE-A 31 00 175 oder DE-A 31 07 741 verwendet.

Geeignete Deckschichten (DS) (auch "Substrat" oder "release layer" genannt) sind im allgemeinen 0,5 bis 20 $\mu$m dick und können aus einem Polymeren bestehen, das lösliche, klebfreie, transparente und reißfeste Filme bildet. Im allgemeinen ist die Deckschicht sauerstoffundurchlässig, so daß sie eine Inhibierung der Photopolymerisation durch Luftsauerstoff in der photopolymerisierbaren reliefbildenden Aufzeichnungsschicht (RS) verhindert. Sie ist nicht klebrig, so daß eine auf sie aufgelegte Bildmaske oder Negativvorlage leicht wieder vom erfindungsgemäßen Aufzeichnungselement abgelöst werden kann. Vorteilhafterweise haftet sie an der Oberfläche der photopolymerisierbaren oder bildmäßig belichteten reliefbildenden Aufzeichnungsschicht (RS) fester als an der ihr gegebenenfalls aufliegenden Deckfolie (DF).

Die optisch transparente Deckschicht (DS) kann glatt sein, d.h. sie kann einen Oberflächenrauhwert $R_{max}$ ≦0,1 µm aufweisen. Vorteilhafterweise ist sie mattiert, d.h. ihr Oberflächenrauhwert $R_{max}$ liegt bei 0,1 bis 15, vorzugsweise 0,3 bis 10 und insbesondere 0,5 bis 7 µm. Durch die Mattierung wird die Zeit, in der die Bildmaske oder Negativvorlage mit dem erfindungsgemäßen Aufzeichnungselement in Kontakt gebracht werden kann, erheblich verkürzt.

Sofern die Dicke der optisch transparenten Deckschicht (DS) geringer ist als ihr Oberflächenrauhwert $R_{max}$, ist die unter der optisch transparenten Deckschicht (DS) liegende Oberfläche der photopolymerisierbaren reliefbildenden Aufzeichnungsschicht (RS) gleichfalls mattiert, was oftmals von Vorteil ist.

Die optisch transparente Deckschicht (DS) enthält in der Hauptsache ein Polymeres, welches zur Bildung reißfester Filme in der Lage ist, oder sie besteht aus einem solchen Polymeren. Die Auswahl des Polymeren für den Aufbau der optisch transparenten Deckschicht (DS) richtet sich in erster Linie nach den Löslichkeitseigenschaften des Polymeren einerseits und der hiermit zu bedeckenden photopolymerisierbaren reliefbildenden Aufzeichnungsschicht (RS) oder deren obersten Einzelschicht andererseits: Die Löslichkeiten können so aufeinander abgestimmt sein, daß die photopolymerisierbare reliefbildende Aufzeichnungsschicht (RS) oder deren oberste Einzelschicht bzw. das darin enthaltene polymere Bindemittel einerseits und die optisch transparente Deckschicht andererseits nicht in ein und demselben Lösungsmittel löslich oder quellbar sind.

Beispiele gut geeigneter Polymerer für optisch transparente Deckschichten (DS), welche in organischen Lösungsmitteln löslich oder quellbar sind, sind Polyamide, Copolyamide, Polyethylen, Polystyrol, Styrol-Acrylnitril-Copolymerisate, Polyvinylchlorid, Vinylchlorid-Vinylacetat-Copolymerisate, Polycarbonate, Silikonkautschuke, Polyester, Polyurethane, Poly(meth)acrylate, Cyclokautschuke eines hohen Cyclisierungsgrades, Ethylen-Propylen-Copolymerisate und Ethylen-Vinylacetat-Copolymerisate.

Beispiele für gut geeignete Polymere für optisch transparente Deckschichten, welche in Wasser oder in wäßrigen Lösungsmitteln löslich oder quellbar sind, sind partiell oder nahezu vollständig hydrolysierte Poly(vinylalkoholalkancarbonsäureester), partiell oder nahezu vollständig hydrolysierte Vinylalkoholalkancarbonsäureester-Polyalkylenoxid-Pfropfmischpolymerisate, Gelatine, Celluloseester, Celluloseether, Polyvinylpyrrolidon, Vinylaromat-Alkandicarbonsäureanhydrid-Copolymerisate, Vinylether-Alkandicarbonsäureanhydrid-Copolymerisate, Poly(meth)acrylsäure, (Meth)Acrylsäure-(Meth)Acrylat-Copolymerisate und Polyalkylenoxide.

Außerdem kann die in Wasser oder in wäßrigen Lösungsmitteln lösliche oder quellbare optisch transparente Deckschicht (DS) aus geeigneten niedermolekularen, in Wasser oder wäßrigen Lösungsmitteln löslichen Verbindungen aufgebaut sein. Beispiele geeigneter Verbindungen sind Saponine und Saccharide.

Beispiele besonders gut geeigneter erfindungsgemäß zu verwendender Polymere für die in Wasser oder in wäßrigen Lösungsmitteln lösliche oder quellbare optisch transparente Deckschicht (DS) sind die partiell oder nahezu vollständig hydrolysierten Poly(vinylalkoholalkancarbonsäureester) und die partiell oder nahezu vollständig hydrolysierten Vinylalkoholalkancarbonsäureester-Polyalkylenoxid-Pfropfmischpolymerisate, von denen partiell oder nahezu vollständig hydrolysiertes Polyvinylacetat oder -propionat mit einem Hydrolysegrad von 60 bis 99 %, vorzugsweise 70 bis 98 Gew.-% und insbesondere 75 bis 95 % und einem zahlenmittleren Molekulargewicht $\overline{M}_n$ von $10^4$ bis $10^5$, insbesondere $1{,}5 \cdot 10^4$ bis $5 \cdot 10^4$ sowie das partiell oder nahezu vollständig hydrolysierte Ethylenoxid-Vinylacetat- und das Ethylenoxid-Vinylpropionat-Pfropfmischpolymerisat, welche durch Pfropfen von Vinylacetat oder -propionat auf Polyethylenoxid und anschließende Hydrolyse erhalten werden und einen Gehalt an einpolymerisiertem Ethylenoxid von 10 bis 30 Gew.-% aufweisen, ganz besonders gut geeignet sind.

Hervorragend geeignet sind die partiell hydrolysierten Vinylacetat-Ethylenoxid-Pfropfmischpolymerisate, die unter der Bezeichnung Mowiol ®04-M1 von der Fa. Hoechst angeboten werden (siehe "Mowiol Polyvinylalkohol", Hoechst-Firmenschrift, 1984).

Geeignete Deckfolien (DF) sind im allgemeinen 20 bis 150 µm dick und bestehen z.B. aus einem Polymeren wie Polyamid oder Polyethylenterephthalat.

Geeignete Antihaftschichten (AS) sind im allgemeinen 0,1 bis 0,5 µm dick und bestehen beispielsweise aus Silikonharzen gemäß EP-A 68 599.

Werden als Schichtträger (T) stark reflektierende Platten oder Folien verwendet, dann können sie geeignete Lichthofschutzmittel, wie Ruß oder Mangandioxid, enthalten. Die Lichthofschutzmittel können aber als separate Schicht auf (T) aufgetragen werden oder in der Haftschicht (HS) oder der reliefbildenden Schicht (RS) enthalten sein.

Die Herstellung solcher Mehrschichtenelemente weist keine methodischen Besonderheiten auf und kann durch Auftragen der reliefbildenden Schicht (RS) auf dem Träger (T) mittels Gießen aus Lösung, Heißpressen, Kalandrieren oder Extrudieren erfolgen. Auf dieses Zweischichtenelement können dann die anderen Schichten in bekannter Weise aufgebracht werden. Es ist aber auch möglich, die Schicht (RS) zuerst auf die mit einer Deckschicht (DS) bedeckten Seite einer Deckfolie (DF) aufzutragen und anschließend die unbedeckte Seite der Schicht (RS) mit dem Träger (T) haftfest zu verbinden.

Aus den Flächengebilden, die aus den Gemischen bestehen, oder aus den Mehrschichtenelementen, die reliefbildende Schichten (RS) aus solchen Gemischen enthalten, können photovernetzte Druckformen, Reliefformen, Photoresists und Folien hergestellt werden. Diese Umwandlung von durch Photopolymerisation vernetzbaren Druckplatten, Reliefplatten, Photoresists oder Folien in durch Photopolymerisation vernetzte Druckformen, Reliefformen, Photoresists oder Folien bietet auch keine methodischen Besonderheiten.

Sie erfolgt - gegebenenfalls nach einer Vorbehandlung - durch bildmäßiges Belichten der Druckplatten, Reliefplatten und Photoresists mit aktinischem Licht einer Wellenlänge zwischen 230 und 450, vorteilhafterweise zwischen 300 und 450 nm durch aufgelegte Negativvorlagen hindurch, Auswaschen der unbelichteten und daher unvernetzten Anteile der Druckplatten, Reliefplatten und Photoresists mit Hilfe geeigneter Entwicklerlösungsmittel, Trocknen der so erhaltenen Formen, die aus einer Reliefschicht (RS') bestehen oder diese enthalten, und gegebenenfalls Nachbehandeln der Formen. Im Falle der Folien erfolgt die Belichtung vollflächig. Es versteht sich von selbst, daß bei photovernetzten Folien, die durch vollflächige Belichtung mit aktinischem Licht hergestellt werden, die weiteren Verfahrensschritte entfallen.

Geeignete Lichtquellen für aktinisches Licht sind z.B. handelsübliche UV-Fluoreszenzröhren, Quecksilbermittel-, -hoch- und -niederdruckstrahler, superaktinische Leuchtstoffröhren, Xenonimpulslampen, mit Metalliodiden dotierten Lampen oder Kohlebogenlampen.

Geeignete Entwicklerlösungsmittel sind Wasser oder wäßrige Lösungsmittel (wäßrige Basen, wäßrigalkoholische Lösungsmittel). Bevorzugt werden wäßrige Basen eingesetzt. Besonders bevorzugt wird Wasser eingesetzt.

Beispiele zur Entwicklung geeigneter wäßriger Basen sind wäßrige Lösungen von Lithium-, Natrium- oder Kaliumhydroxid oder von Lithium-, Natrium- oder Kaliumcarbonat oder -hydrogencarbonat oder von Ammoniak. Beispiele geeigneter wäßrig-alkoholischer Entwicklungslösungsmittel sind wäßrige Lösungen, die Methanol, Ethanol, Isopropanol oder n-Butanol in untergeordneten Mengen enthalten. Die Entwicklerlösungsmittel können noch feste, flüssige oder gasförmige organische und anorganische Verbindungen, wie etwa Tenside, Komplexbildner oder Salze, in untergeordneten Mengen enthalten.

Beispiele für geeignete Nachbehandlungsmethoden sind die Nachbehandlung mit bromhaltigen Lösungen, das vollflächige Nachbelichten mit aktinischem Licht einer Wellenlänge $\lambda$ zwischen 250 und 450 nm sowie das Nachbelichten mit Licht einer Wellenlänge $\lambda$ kleiner als 250 nm.

Für den Fall, daß reliefbildende Schicht (RS) und Deckschicht (DS) unterschiedliche Lösungseigenschaften haben, kann das lichtempfindliche Aufzeichnungselement entsprechend der deutschen Anmeldung Nr. P 39 08 763.8 mit einer Wasser-in-Öl-Emulsion oder Öl-in-Wasser-Emulsion in einem Arbeitsgang entwickelt werden.

Die Dicke der Reliefschicht (RS') der Formen variiert je nach Anwendungszweck von 0,001 bis 7 mm, von Vorteil sind Dicken von 0,025 bis 6,5 mm.

Die in dieser Weise erhaltenen Druckformen können auf Druckzylinder aufgebracht, gegebenenfalls durch Coronaentladungen aufgerauht und für den Endlosdruck verwendet werden.

Die Gemische weisen bei ihrer Herstellung und Verarbeitung zahlreiche Vorteile auf. So lassen sie sich sehr leicht nach den üblichen Verfahren verarbeiten, wobei insbesondere ihre gute Dosierbarkeit in Krümelform das Beschicken von Extrudern erleichtert, wodurch sich im allgemeinen eine Mitverwendung von Trennmitteln erübrigt. Die verarbeiteten Massen und Formen sind klar und transparent, was vor allem erlaubt, photovernetzte Druckformen, Reliefformen und Photoresists mit Reliefschichten (RS') von sehr hoher Relieftiefe mit gutem Flankenaufbau herzustellen. Dies ist z.B. für das Bedrucken rauher, welliger Oberfläche, z.B. von Wellpappe, Kartonagen oder Servietten unbedingt erforderlich. Reliefhöhen von über 3 mm sind daher ohne Probleme wie bei konventionell geprägten Gummiklischees herstellbar, ohne daß es in der Tiefe der Schichten zum "Zupolymerisieren" kommt. Nicht zuletzt erlaubt die Klarheit der Gemische kurze Belichtungszeiten, ohne daß dies einen nicht aktzeptablen Polymerisationsgradienten in den Reliefschichten (RS') zur Folge hätte. Die belichteten Massen und Formen sind stabil gegenüber äußeren chemischen und physikalischen Einflüssen und nicht klebrig. Insbesondere besitzen die Druckformen eine hohe Beständigkeit gegenüber Druckfarbenlösungsmitteln und eine hohe Abriebfestigkeit, was sehr hohe Druckauflagen ermöglicht. Der Hauptvorteil der photopolymerisierten Massen und Formen auf der Basis der erfindungsgemäßen Polymerisate ist ihre Rißbeständigkeit.

Nach der Belichtung können die Mehrschichtenelemente in reinem Wasser bei Raumtemperatur zum Klischee entwickelt werden. Die Belichtungs- und Auswaschzeiten liegen im Bereich weniger Minuten.

Als Ergebnis der Pfropfreaktion ist die Wasserlöslichkeit der nicht belichteten Teile stark verbessert,

ohne daß die Quellbeständigkeit abgenommen hat. Eine ausgezeichnete Löslichkeitsdifferenzierung liegt somit vor.

Die Lösungsmittelaufnahme der belichteten Schichten in Wasser, Ethanol und Essigester ist sehr niedrig, was für den Druck von hohen Auflagen (Auflagendruck) von großer Bedeutung ist. Dabei weisen die belichteten und ausgewaschenen Klischees niedrige die Härte charakterisierende Shore A Werte und sehr hohe Reißdehnungswerte auf und sind daher insbesondere als Flexodruckformen gut geeignet.

Zusätzlich zu den vorstehend angegebenen Verwendungszwecken können die erfindungsgemäßen Polymerisate auch noch für die Herstellung von Schmelzklebern, Haftvermittlern, Antidröhnmassen, Dämpfungsmassen für mechanische Stöße oder von Lacken verwendet werden. Desweiteren eignen sie sich als Zusatzstoffe für Thermoplaste, synthetische Kautschuke oder Bitumen.

Beispiele

Die Beispiele 1 bis 6 entsprechen photopolymerisierbaren Aufzeichnungsmaterialien. Beispiele 1 bis 4 sind erfindungsgemäß. Beispiele 5 und 6 sind Vergleichsbeispiele.

Den Beispielen 1 bis 6 sind die Versuche 1 und 2 vorangestellt. Versuch 1 beschreibt die Herstellung eines für die erfindungsgemäßen Aufzeichnungsmaterialien verwendeten Emulsionspolymerisats. Versuch 2 belegt eine polymeranaloge Umsetzung von bekannten Ethylen-Acrylsäure-Copolymerisaten mit einer Substanz, welche in den erfindungsgemäßen Polymeren als Pfropfungsmonomer reagiert.

In den folgenden Beispielen und Versuchen ist unter "Säurezahl" die Menge von 100 %iger KOH in mg zu verstehen, die zur Neutralisation von 1 g Produkt benötigt wird. Die Shore-A-Härte wurde nach DIN 53 505 und die Quellung der Proben in Gew.% nach 24stündiger Lagerung in $H_2O$ oder Ethanol bestimmt.

Versuch 1:

Herstellung eines Emulsionspolymerisats

In einem Stahlautoklaven mit Rührer, Temperaturregelung und Zulaufvorrichtungen wurde unter Stickstoff ein Gemisch aus 1081 Gew.-Teilen vollentsalztem Wasser, 1,5 Gew.-Teilen Ethylendiamintetraessigsäure-Natriumsalz, 4,6 Gew.-Teilen Natriumformaldehydsulfoxylat, 23,2 Gew.-Teilen einer 40 %igen Lösung eines Natriumalkylsulfonats mit einer Kettenlänge von 12 bis 16 C-Atomen, 6 % des nachstehend beschriebenen Zulaufs 1 sowie 9 % des nachstehend beschriebenen Zulaufs 2 vorgelegt. Dann wurde auf 60 °C aufgeheizt und 10 min anpolymerisiert und der Rest einer Mischung aus 3089,6 Gew.-Teilen vollentsalztem Wasser, 57,7 Gew.-Teilen einer 40 %igen Lösung des Natriumalkylsulfonats, 1158,2 Gew.-Teilen Methacrylsäure, 694,9 Gew.-Teilen Methylmethacrylat, 463,3 Gew.-Teilen n-Butylacrylat, 2316,5 Gew.-Teilen Butadien und 92,6 Gew.-Teilen tert.-Dodecylmercaptan (Zulauf 1) sowie der Rest einer Lösung von 13,9 Gew.-Teilen Natriumperoxodisulfat in 926,6 Gew.-Teilen vollentsalztem Wasser (Zulauf 2) in 3,5 h parallel in den Autoklaven zudosiert. Der Autoklaveninhalt wurde noch 7 h unter Rühren bei 60 °C belassen; dann wurde entspannt und 77,2 Gew.-Teile einer 25 %igen Lösung von Ammoniak in Wasser zugegeben. Die resultierende Dispersion hatte einen Feststoffgehalt von 46,3 %.

Anschließend wurde die Dispersion einer Gefriertrocknung unterworfen.

Es resultierte ein weiches transparentes Polymerisat mit einer Säurezahl von 163 mg KOH/g Polymer.

Versuch 2:

Entsprechend Beispiel 1 aus EP-A 231 002 wurde ein Ethylen-Acrylsäure-Copolymerisat mit Glycidylmethacrylat umgesetzt. Das resultierende Polymer hatte die theoretisch für die Umsetzung von jeweils einer Säurefunktion mit jeweils einem Glycidylmethacrylatmolekül erwartete Säurezahl. Es erfolgte also eine polymeranaloge Umsetzung.

Beispiel 1

Herstellung des Pfropfcopolymeren

148,5 Gew.-Teile des in Versuch 1 hergestellten Emulsionspolymerisates, 0,74 Gew.-Teile p-Dimethylaminopyridin und 0,7 Gew.-Teile 2,6-Di-t-butyl-p-kresol wurden in 222,8 Gew.-Teilen Toluol gelöst. Die Lösung wurde auf 80 °C erwärmt und 12,2 Gew.-Teile Glycidylmethacrylat zugetropft. Anschließend wurde 3 h unter Rückfluß gekocht. Der Gehalt an freiem Glycidylmethacrylat in der Lösung war kleiner als 0,1

Gew.-%. Das entstandene Pfropfcopolymer wurde in kaltem Wasser ausgefällt und hatte eine Säurezahl von 145 mg KOH/g Polymer. Daraus ergibt sich die Zahl n der pro umgesetzter Säurefunktion durchschnittlich angelagerten Monomermoleküle zu 5,3.

Herstellung des photopolymerisierbaren Aufzeichnungsmaterials

Zu der Lösung des Pfropfcopolymeren in Toluol wurden 8 Gew.-Teile KOH als konzentrierte wäßrige Lösung bei 80 °C zugetropft.

Anschließend wurden die übrigen Rezepturbestandteile in der folgenden Reihenfolge zugegeben: Ölsäure 16,1 Gew.-Teile, 2-Ethylhexylacrylat 8 Gew.-Teile und Benzildimethylketal 1,92 Gew.-Teile. Die Lösung wurde am Rotavapor eingeengt und auf eine mit einer 5 µm dicken Polyvinylalkoholfolie (Mowiol ®.04-M1 der Firma Hoechst) beschichtete 125 µm dicke Polyethylenterephthalatfolie gegossen, 2 h bei 70 °C getrocknet und auf eine mit einem Haftlack beschichtete Trägerfolie kaschiert.

Nach Abziehen der Polyethylenterephthalatfolie wurde die Schicht durch eine Negativvorlage bildmäßig belichtet und anschließend in vollständig entionisiertem Wasser bei Raumtemperatur in einem Reibewascher zum Klischee entwickelt.

Beispiel 2

Herstellung des Pfropfcopolymeren

Wie in Beispiel 1, nur daß zum Emulsionspolymerisat 30 Gew.-Teile 2-Methylglycidylacrylat statt 12,2 Gew.-Teile Glycidylmethacrylat zugegeben wurden. Aus der experimentell bestimmten Säurezahl ergab sich n = 16.

Herstellung des photopolymerisierbaren Aufzeichnungsmaterials wie in Beispiel 1.

Beispiel 3

Herstellung des Pfropfcopolymeren wie in Beispiel 1.

Herstellung des photopolymerisierbaren Aufzeichnungsmaterials wie in Beispiel 1, nur daß als Neutralisationsagens 10 Teile Diethanolamin eingesetzt wurden.

Beispiel 4

Herstellung des photopolymerisierbaren Aufzeichnungsmaterials im Extruder

In einem Zweischneckenextruder wurde ausgehend von dem Emulsionspolymerisat aus Versuch 1 das Pfropfcopolymer und daraus das photopolymerisierbare Aufzeichnungsmaterial hergestellt. Hierbei wurden folgende Bestandteile verwendet (Gesamtdurchsatz = 30 kg/h):

| | |
|---|---|
| Polymerisat aus Versuch 1 | 8000 Gew.-Teile/h |
| 2-Methylglycidylmethacrylat | 184 Gew.-Teile/h |
| KOH (Plätzchen) | 110 Gew.-Teile/h |
| Hexandioldiacrylat | 221 Gew.-Teile/h |
| Benzildimethylketal | 44 Gew.-Teile/h |
| Cetamoll® BMB | 368 Gew.-Teile/h |
| 2,6-Di-t-butyl-p-kresol | 30 Gew.-Teile/h |

Zunächst wurde die Dispersion in den Extruder gepumpt und in drei aufeinanderfolgenden Entgasungseinheiten das Wasser abgezogen. In der Aufschmelzzone wurde 2,6-Di-t-butyl-p-kresol zugegeben.

Anschließend wurde das Pfropfagens zudosiert und bei Verweilzeiten von wenigen Minuten und Temperaturen von 140 °C quantitativ umgesetzt. Danach wurde die KOH eingemischt und Cetamoll und Benzildimethylketal, welches in Hexandioldiacrylat vorgelöst wurde, zudosiert.

Die aufgeschmolzene Masse wurde durch eine Breitschlitzdüse extrudiert und zwischen zwei beschichteten Trägerfolien (obere Walze mit Haftlack beschichtet, untere Walze mit Mowiol ® 04/M1 der Fa. Hoechst beschichtet) zu toleranzgenauen Schichten der Stärke 700 µ (ohne Folien) geformt. Die Analyse der

Schichten ergab, daß pro umgesetzter Säurefunktion 10 Monomermoleküle angelagert wurden.

Beispiel 5

Herstellung des photopolymerisierbaren Aufzeichnungsmaterials

Wie in Beispiel 1, nur wurde das nicht gepfropfte Emulsionspolymerisat aus Versuch 1 verwendet.

Beispiel 6

Herstellung des photopolymerisierbaren Aufzeichnungsmaterials

Wie in Beispiel 1, nur wurde das durch polymeranaloge Umsetzung von Ethylen-Acrylsäure-Copolymer mit Glycidylmethacrylat erhaltene Polymerisat aus Versuch 2 statt des gepfropften Emulsionspolymerisats verwendet.

Der Vergleich der erfindungsgemäßen photopolymerisierbaren Aufzeichnungsmaterialien (Beispiele 1 bis 4) mit solchen nach dem Stand der Technik (Beispiele 5 und 6) zeigt die Vorteile der erfindungsgemäßen Pfropfcopolymerisate (siehe Tabelle).

Die Vorteile der photopolymerisierten Massen und Formen auf der Basis der erfindungsgemäßen Polymerisate zeigen sich bei der Verarbeitung zum Klischee und bei der physikalisch-chemischen Charakterisierung der Schichten (siehe Tabelle):

Tabelle

| Bsp. | Belichtungszeit (Minuten) | Auswaschzeit (Minuten) | Shore A | Quellung** in $H_2O$ (Gew.-%) | Ethanol (Gew.-%) | RD **) |
|---|---|---|---|---|---|---|
| 1 | 6 | 6 (Wasser, RT) | 55 | 12 | 18 | 200 |
| 2 | 4 | 3 (Wasser, RT) | 65 | 10 | 14 | 180 |
| 3 | 7 | 7 (Wasser, RT) | 50 | 8 | 19 | 240 |
| 4 | 6 | 7 (Wasser, RT) | 60 | 8 | 16 | 180 |
| 5* | 16 | 12 (Wasser, RT) | 45 | 220 | 40 | 400 |
| 6* | 6 | 14 (Wasser, 60°C)) | 55 | 10 | 16 | 80 |

*) Vergleichsbeispiele

**) Quellung und Reißdehnungswerte wurden an korrekt belichteten und ausgewaschenen Klischees bestimmt; Reißdehnung nach ASTM D 638 bestimmt.

Die für gute Druckergebnisse entscheidende Kombination aus guter Quellbeständigkeit gegenüber Druckfarbenlösungsmitteln und hoher Weichelastizität zeigen nur die erfindungsgemäßen Formulierungen, die außerdem noch den Vorteil der Entwickelbarkeit in reinem Wasser bei Raumtemperatur aufweisen.

## Patentansprüche

1. Modifizierte Polymerisate in Säureform oder in Form ihrer Salze, aufgebaut im wesentlichen aus
   A) einem durch Emulsionspolymerisation hergestellten, Carboxylgruppen enthaltenden, Copolymerisat

   und
   B) hierin durch partielle Pfropfung an den Carboxylgruppen eingeführten seitenständigen Resten der allgemeinen Formel I,

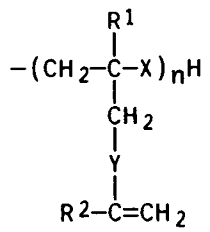

I,

in denen

- $R^1$ ein Wasserstoffatom oder eine $C_1$- bis $C_5$-Alkylgruppe,
- $R^2$ ein Wasserstoffatom oder eine $C_1$- bis $C_5$-Alkylgruppe,
- X ein Sauerstoffatom, ein Schwefelatom oder eine Imingruppe,
- Y eine Ester-, eine Amid-, eine Ether- oder eine $C_1$- bis $C_{10}$-Alkylengruppe bedeutet,

und $1 < n \leqq 100$ für die mittlere Anzahl n der pro umgesetzter Säurefunktion angelagerten Monomereinheiten gilt.

**2.** Polymerisate nach Anspruch 1, dadurch gekennzeichnet, daß das Copolymerisat A) durch Emulsionspolymerisation von

- $a_1$) 40 bis 80 Gew.-% mindestens eines konjugierten Diens,
- $a_2$) 10 bis 50 Gew.-% mindestens einer ethylenisch $\alpha,\beta$-ungesättigten Säure, und
- $a_3$) 0 bis 50 Gew.-% mindestens eines ethylenisch ungesättigten Monomeren

erhalten wurde und der Anteil der Reste B) im modifizierten Copolymerisat 3 bis 30 Gew.-%, bezogen auf das unmodifizierte Polymerisat, beträgt.

**3.** Polymerisate nach Anspruch 2, dadurch gekennzeichnet, daß das konjugierte Dien $a_1$) Butadien und die ethylenisch $\alpha,\beta$-ungesättigte Säure $a_2$) Methacrylsäure ist.

**4.** Photopolymerisierbare Aufzeichnungsmaterialien, dadurch gekennzeichnet, daß sie

- $b_1$) 50 bis 95 Gew.-% eines modifizierten Emulsionspolymerisats gemäß einem der Ansprüche 1 bis 3,
- $b_2$) 2 bis 30 Gew.-% mindestens einer polymerisierbaren ein- oder mehrfach ethylenisch ungesättigten monomeren organischen Verbindung und
- $b_3$) 0,01 bis 5 Gew.-% mindestens eines Photopolymerisationsinitiators enthalten.

**5.** Aufzeichnungsmaterialien nach Anspruch 4, dadurch gekennzeichnet, daß sie zusätzlich, bezogen auf die Summe der Komponenten $b_1$ bis $b_6$,

- $b_4$) bis 30 Gew.-% Weichmacher,
- $b_5$) bis 2 Gew.-% Farbstoff,
- $b_6$) bis 30 Gew.-% einer oder mehrerer zusätzlicher Komponenten

enthalten.

**6.** Aufzeichnungsmaterialien nach den Ansprüchen 4 oder 5, dadurch gekennzeichnet, daß die Säurezahl der aus den Komponenten $a_1$) bis $a_3$) erhaltenen Emulsionspolymerisate zwischen 50 und 200 mg KOH/g Polymer liegt und der Anteil der Reste B) im modifizierten Emulsionspolymerisat 3 bis 30 Gew.-% beträgt.

**7.** Druckplatte mit in der angegebenen Reihenfolge angeordnet einer Trägerfolie, einer Haftschicht, einer reliefbildenden Schicht, einer Deckschicht und einer Deckfolie, dadurch gekennzeichnet, daß die reliefbildende Schicht aus dem photopolymerisierbaren Aufzeichnungsmaterial nach den Ansprüchen 4 bis 6 besteht.

**8.** Druckplatte nach Anspruch 7, dadurch gekennzeichnet, daß die Deckschicht aus einem partiell oder nahezu vollständig hydrolysierten Vinylalkoholalkancarbonsäureester-Polyalkylenoxid-Pfropfmischpolymerisat besteht.

**9.** Druckplatte nach Anspruch 7, dadurch gekennzeichnet, daß die Deckschicht aus einem partiell oder nahezu vollständig hydrolysierten Poly(vinylalkoholalkancarbonsäureester) besteht.

**10.** Verwendung der Polymerisate gemäß einem der Ansprüche 1 bis 3 zur Herstellung von photovernetzbaren Druckplatten, Reliefplatten und Photoresists.

**11.** Verfahren zur Herstellung eines photopolymerisierbaren Aufzeichnungsmaterials, gekennzeichnet dadurch, daß man hierbei

a) in einer Emulsionspolymerisation

- $a_1$) 40 bis 80 Gew.-% mindestens eines konjugierten Diens,
- $a_2$) 10 bis 50 Gew.-% mindestens einer ethylenisch $\alpha,\beta$-ungesättigten Säure,
- $a_3$) 0 bis 50 Gew.-% mindestens eines ethylenisch ungesättigten Monomeren

umsetzt und das entstandene Emulsionspolymerisat

b) nach Entfernung des Wassers in einem Lösungsmittel mit 3 bis 30 Gew.-%, bezogen auf das Emulsionspolymerisat, einer Verbindung der allgemeinen Formel II,

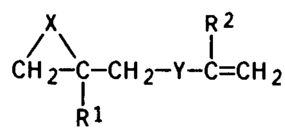

II

worin

- $R^1$ ein Wasserstoffatom oder eine $C_1$- bis $C_5$-Alkylgruppe,
- $R^2$ ein Wasserstoffatom oder eine $C_1$- bis $C_5$-Alkylgruppe,
- X ein Sauerstoffatom, ein Schwefelatom oder eine Imingruppe,
- Y eine Ester-, eine Amid-, eine Ether- oder eine $C_1$- bis $C_{10}$-Alkylengruppe bedeutet,

umsetzt und

c) gegebenenfalls das hierbei entstandene, in der Säureform vorliegende, modifizierte Emulsionspolymerisat mit Basen teilweise oder vollständig in die salzartige Form überführt

und

d)

- $b_1$) 50 bis 95 Gew.-% des hierdurch erhaltenen modifizierten Emulsionspolymerisats mit
- $b_2$) 2 bis 30 Gew.-% mindestens einer polymerisierbaren ein- oder mehrfach ethylenisch ungesättigten monomeren organischen Verbindung, und
- $b_3$) 0,01 bis 5 Gew.-% mindestens eines Photopolymerisationsinitiators,
- $b_4$) bis 30 Gew.-% Weichmacher,
- $b_5$) bis 2 Gew.-% Farbstoff, und
- $b_6$) bis 30 Gew.-% einer oder mehrerer zusätzlicher Komponenten

mischt und in dünne Schichten formuliert.

**12.** Verfahren nach Anspruch 11, dadurch gekennzeichnet, daß mindestens die Teilschritte b) bis d) in einem Extruder durchgeführt werden, wobei das Wasser durch Anlegen von Vakuum entfernt wird und alle weiteren Umsetzungen, Mischungen und Formulierungen in der Schmelze des Emulsionspolymerisates erfolgen.

**13.** Verfahren nach Anspruch 11 oder 12, dadurch gekennzeichnet, daß man als konjugiertes Dien $a_1$) Butadien und als ethylenisch $\alpha,\beta$-ungesättigte Säure $a_2$) Methacrylsäure verwendet.